# EUROPEAN PATENT APPLICATION

(11) **EP 2 202 435 A1**
(43) Date of publication of application: **30.06.2010**
(21) Application number: 08172337.1
(22) Date of filing: 19.12.2008
(51) Int. Cl.: F16K 41/00

(54) **Arrangement for the regulation of a gas stream**

(71) Applicant: Applied Materials, Inc., Santa Clara, CA 95054 (US)
(72) Inventor: Sommer, Elisabeth, 63755 Alzenau (DE); König, Michael, 60529 Frankfurt (DE)
(74) Representative: Schickedanz, Willi

(57) **Abstract**

The invention relates to an arrangement for the regulation of a gas stream, with a dosing pipe (16) for gas as well as a conduit pipe (10) disposed thereon. The dosing pipe (16) can be closed with a tappet (25) located on a movable rod (18). A device provides an inert gas stream directed counter to the gas stream.

## Description

The invention relates to an arrangement according to the preamble of patent claim 1.

When coating substrates with certain substances, the substances are converted into the gaseous state and subsequently conducted to the substrate. The substances can, for example, be heated in a crucible and made to vaporize. The vapor is subsequently supplied, for example via guide elements, to the substrate.

EP 1 672 715 A1 discloses an arrangement for coating a substrate, which arrangement comprises a vaporizer source, a vapor guide device and a mechanical vapor block in the vapor guide device. The vapor block is herein realized as a valve comprised of quartz. This valve can be opened or closed.

An arrangement for vacuum coating is furthermore known, which comprises a crucible in which organic material is heated and vaporized (WO 2006/061517 Al). Between this crucible and the coating chamber is disposed a valve with which the vapor is controllable. The valve is herein realized as a horizontally movable gate valve.

In an OLED vaporizer source a valve is provided in order to stop the material stream when the vaporizer source is not being operated. Since the vaporized organic material is chemically reactive, those parts which come into contact with the organic material, are produced of quartz, which enters only with difficulty into chemical reactions. Said parts are heated to temperatures which exclude condensation of the vaporized organic material. However, at these temperatures the conventional elastic seals are destroyed. Consequently, it is not possible to close the piston of a valve securely.

In the case of conventional valves, which could only assume the states "open" or "closed", the sealing did not represent a major problem. The piston was simply inserted into an opening of the vaporizer source to close it and pulled out for opening it. Yet to be able to regulate the vaporizer rate better, it is necessary to open or close continuously the opening of the vaporizer source by moving the piston.

However, hereby vapor flows nearly continuously out of the vaporizer source and about the piston, since during normal operation the end positions of the piston are practically never reached. This leads to an undesirable contamination of the vaporizer source and its surroundings. Moreover, a portion of the expensive organic material is lost.

The invention therefore addresses the problem of preventing or reducing the contamination of the vaporizer source and its surroundings even if the vaporizer source is continuously opened and closed.

This problem is solved according to the features of patent claim 1.

The invention consequently relates to an arrangement for the regulation of a gas stream with a dosing pipe for gas as well as a conduit pipe disposed thereon. The dosing pipe can be closed with a tappet located on a movable rod.

The advantage attained with the invention comprises that the gas stream directed counter to the vaporized material suppresses the material flow on the inside of the valve. While the gas stream flowing also about the outside of the valve is not necessarily desirable, it can, however, be accepted.

An embodiment example of the invention is shown in the drawing and will be explained further detail in the following. In the drawing depict:
Fig. 1 a view of a valve regulation together with portions of a vacuum coating chamber,
Fig. 2 an enlarged representation of a valve without counterflowing gas,
Fig. 3 a variant of the valve according to Fig. 2, however, with counterflowing gas,
Fig. 4 a variant of the valve depicted in Fig. 3.

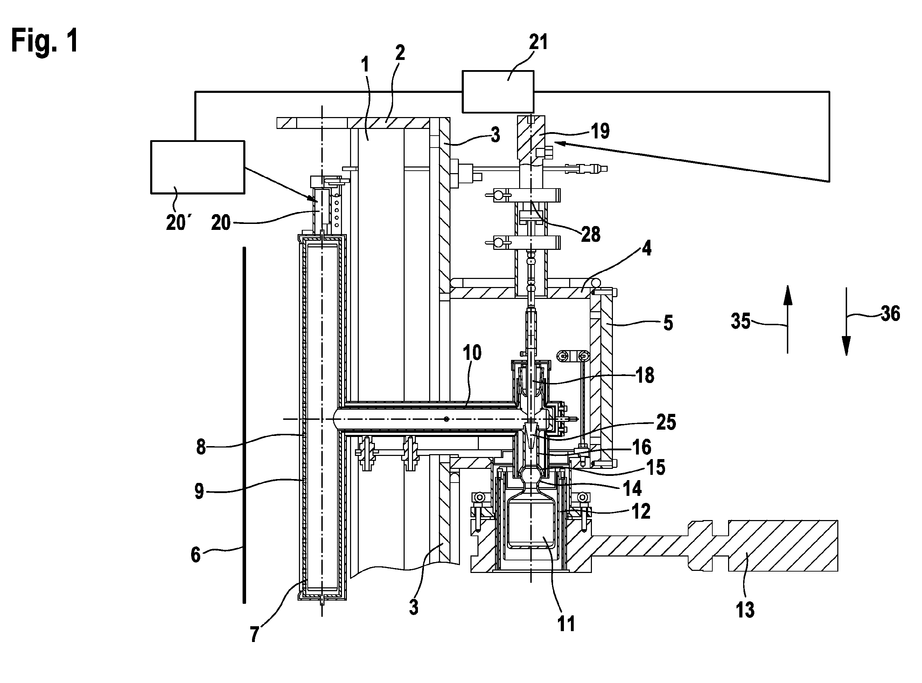

Figure 1 shows a subregion of a vacuum chamber 1 delimited by walls 2 and 5. In this vacuum chamber 1 is located a substrate 6, for example a glass sheet, which is to be coated with a substance, for example an organic substance, to produce, for instance, OLEDs (OLEDs = Organic Light Emitting Diodes). The substrate 6 is preferably coated with small organic molecules, for example for the production of SMOLEDs (SMOLEDs = Small Molecules Organic Light Emitting Diodes) or organic thin film solar cells. The coating takes preferably place under high vacuum. The coating is carried out via a vertical conduit pipe 7 which is provided with several linearly disposed holes 8, 9 and connected with a conduit pipe 10. Together with the vertical conduit pipe 7, the conduit pipe 10 forms a vapor conduit 7, 10, by means of which the vapor is conducted in the direction toward the substrate 6. With its one end the conduit pipe 10 is coupleable with a supply container, for example a vaporizer crucible 11, which is encompassed by a heater 12. In this vaporizer crucible 11 is disposed the material to be vaporized. Instead of the vaporizer crucible 11, a supply container is also conceivable in which is disposed hot organic vapor which can be fed in various ways. The vaporizer crucible 11 can be isolated by means of a gate valve 13 from the vacuum chamber 1. The vaporizer crucible 11 has in its upper region a cupola-shaped formation 14, which can be closed on its topside with a calotte-shaped termination 15. This termination 15 is connected with a dosing pipe 16 which transitions over into the conduit pipe 10. Into the dosing pipe 16 projects a closure which in Figure 1 is developed as a conical tappet 25 forming the end of a rod 18, which rod 18 is movable vertically, i.e. in the direction of arrows 35 and 36. For the vertical movement a drive 19, only shown schematically, is provided which, via a vacuum lead-through 28, acts on the rod 18. The rate of the vaporizer material serving for the coating is acquired by means of a measuring instrument 20', 20 and supplied to a regulator 21, preferably a PID regulator. This regulator 21 controls the schematically shown drive 19 such that the conical tappet 25 can be moved upwardly or downwardly, whereby more or less vaporized material is conducted into the conduit pipe 10. It is obvious to a person of skill in the art that the tappet 25 can also have a different form (for example a cupola-shaped one), provided this tappet can close off the dosing pipe 16. The drive 19, the tappet 25 and the rod 18 form consequently a regulating valve 25, 18, 19.

In principle, to the conduit pipe 10 several vaporizer crucibles can also be connected simultaneously. However, in this case it is necessary that each of these vaporizer crucibles is connected to a regulating valve comprised of a drive and a tappet connected via a rod with the drive. As is also the case in the vaporizer crucible 11, each of these vaporizer crucibles comprises a gate valve 13. In these vaporizer crucibles can be disposed different or like materials to be vaporized. Since these vaporizer crucibles also include heating devices independent of one another, the vaporizer crucibles can alternately be connected to the vacuum chamber and the material disposed in them be vaporized. It is herein not necessary to interrupt the coating process. Since each vaporizer crucible comprises a gate valve, the vaporizer crucibles can therewith be isolated off from the vacuum chamber independently of one another. Replenishing the vaporizer crucibles with material, thus proves to be simple. Via the particular regulating valve, materials can simultaneously be vaporized from one or several vaporizer crucibles. Therewith several vaporizer crucibles can also determine the vaporization rate simultaneously. By slowly opening a regulating valve of a first vaporizer crucible and simultaneously slowly closing a regulating valve of a second vaporizer crucible, the vaporization can be switched over to another vaporizer crucible without interruption of the production.

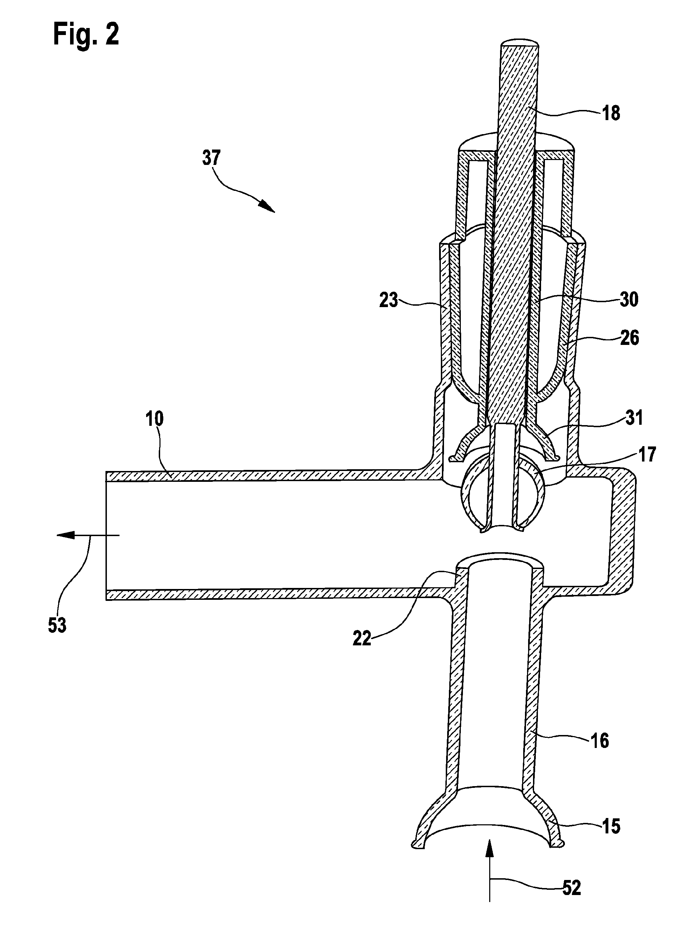

Figure 2 shows a valve 37 in detail. Evident is herein the rod 18, at the lower end of which is disposed a tappet 17. This tappet 17, however, is structured in the shape of a cupola and not in that of a cone. The rod 18 is surrounded by a tube 30 which encompasses the rod 18 and includes at its lower end a calotte-shaped end 31. A conical connection piece 26 encompasses the tube 30. This conical connection piece 26 is disposed in a conical ground joint of a fitting 23. Thus, together with the fitting 23, connection piece 26 forms a vapor-tight closure. This fitting 23 forms the upper portion of the conduit pipe 10. All of the structural parts shown are comprised of quartz.

An arrow 52 indicates the direction of flow of a vaporized organic material which had been vaporized in a crucible not shown in Fig. 2. The movement of the vaporized organic material in the direction toward the substrate is shown by an arrow 53. During the operation the vaporized material also flows around the tappet 17 and the calotte-shaped end 31. The tube 30 cannot be in such close contact on the outer wall of the rod 18 that no vapor escapes. This is due to the fact that rod 18 is moved relative to tube 30.

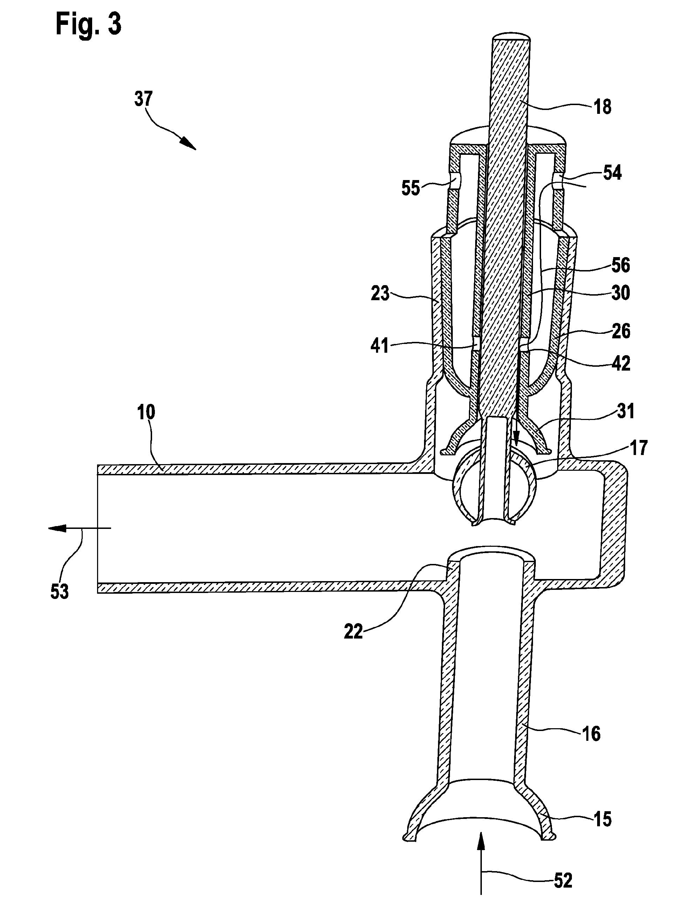

Figure 3 shows the manner in which it is possible to prevent vaporized organic material from penetrating outwardly through the gap between tube 30 and rod 18. For this purpose the connection piece 26 is provided with holes 54, 55 through which flows inert gas. The flow of the gas is indicated by the arrow piece 56. The pressure of the inert gas must herein be at least as high as the pressure of the vaporized material about the tappet 17.

Holes 54, 55 are connected via a common duct with a gas supply, for example a gas tank, which contains the inert gas. This gas can be, for example, argon. In order to be able to interrupt or regulate the gas supply, the duct, which connects the gas supply with the holes 54, 55, includes valves. However, for the sake of clarity the duct, the gas supply as well as the valves are not shown in Figure 3.

The pressure of the inert gas conducted in the direction of arrow 56 into the conduit pipe 10 is preferably higher or at least as high as the pressure of the vaporized material which is conducted into the conduit pipe 10. Therewith the quantity of vaporizing material, which can penetrate outwardly through the gap between tube 30 and rod 18, is markedly reduced.

In tube 30 are preferably provided two holes 41, 42 through which the inert gas flows into the lower interspace between rod 18 and tube 30. However, more than two holes 41, 42, for example three or four holes, can also be provided. It is further possible to provide an annular channel instead of several holes. In this annular channel the gas can already become uniformly distributed before it reaches the conduit pipe 10. In the conduit pipe 10 a mixture of inert gas and material to be vaporized is now transported in the direction of arrow 53. By controlling the drive 19, and therewith the position of tappet 17, the quantity of vaporized material can be set. The drive 19 cannot be seen in figure 3, however.

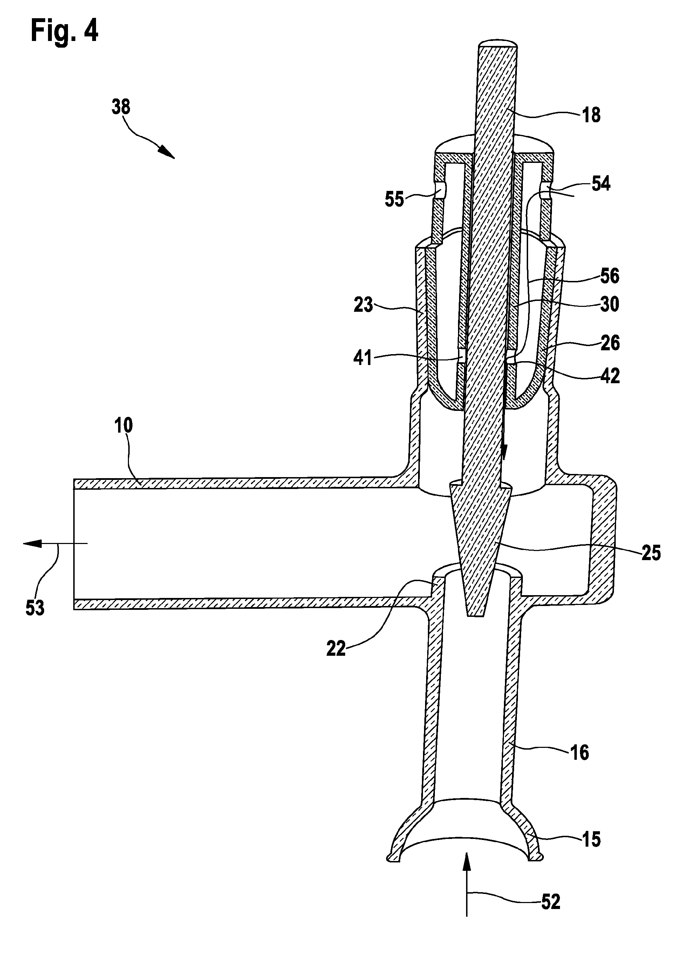

Figure 4 depicts a variant of the valve 37 shown in Figure 3. However, in this valve 38 the tappet 25 is not shaped like a cupola, but rather conically. The form of sealing extension 22 and of end 31 is adapted such that it conforms to the shape of tappet 25. Consequently, the quantity of vapor reaching into the conduit pipe 10 can be readily regulated with the cupola-shaped tappet 17 as well as also with the conical tappet 25.

Evident are also the two holes 54, 55 which are connected via a common duct with a gas supply for an inert gas. This gas supply, however, is not shown in Figure 4. The inert gas is conducted from this gas supply in the direction of arrow 56 into the conduit pipe 10. The pressure of this inert gas is here at least as high as the pressure of the vaporized material.

Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

### Reference numerals

- 1: vacuum chamber
- 2: wall
- 3: wall
- 4: wall
- 5: wall
- 6: substrate
- 7: vertical conduit pipe
- 8: hole
- 9: hole
- 10: conduit pipe
- 11: vaporizer crucible
- 12: heater
- 13: gate valve
- 14: cupola-shaped formation
- 15: calotte-shaped termination
- 16: dosing pipe
- 17: tappet
- 18: rod
- 19: drive
- 20: measuring instrument
- 21: regulator
- 22: sealing extension
- 23: fitting
- 24:
- 25: tappet
- 26: connection piece
- 27:
- 28: vacuum lead-through
- 29:
- 30: tube
- 31: calotte-shaped end
- 32:
- 33:
- 34:
- 35: arrow
- 36: arrow
- 37: valve
- 38: valve

- 41: hole
- 42: hole

- 52: arrow
- 53: arrow
- 54: hole
- 55: hole
- 56: arrow piece

## Claims

1. Arrangement for the regulation of a gas stream, **characterized by**
a) a dosing pipe (16) for gas,
b) a conduit pipe (10) for gas,
c) a tappet (17, 25) for closing the dosing pipe (16), wherein the tappet (17, 25) is disposed on a movable rod (18),
d) a device for providing a gas stream directed counter to the gas stream.

2. Arrangement as claimed in claim 1, **characterized in that** the movable rod (18) is encompassed by a tube (30) which includes holes (41, 42) for the entrance of an inert gas into the interspace between the rod (18) and the tube (30).

3. Arrangement as claimed in claim 2, **characterized in that** the tube (30) is encompassed by a connection piece (26) which includes holes (54, 55) for the entrance of the inert gas.

4. Arrangement as claimed in claim 3, **characterized in that** the connection piece (26) is encompassed by a fitting (23) which represents a protuberance of the conduit pipe (10).

5. Arrangement as claimed in claim 1, **characterized in that** the movable rod (18) includes at its one end the cupola-shaped tappet (17).

6. Arrangement as claimed in claim 1, **characterized in that** the movable rod (18) includes at its one end the conical tappet (25).

7. Arrangement as claimed in claim 1, **characterized in that** the tappet (17) is located opposite a sealing extension (22) disposed on the dosing pipe (16).

8. Arrangement as claimed in claim 2, **characterized in that** the tube (30) includes a calotte-shaped end (31).

9. Arrangement as claimed in claim 5 and claim 8, **characterized in that** the calotte-shaped end (31) is located opposite the cupola-shaped tappet (17).

## Amended claims

### Amended claims in accordance with Rule 137(2) EPC.

**1.** Arrangement for the regulation of a gas stream in a vacuum chamber (1) in which a substrate is to be coated comprising
a) a dosing pipe (16) for gas,
b) a conduit pipe (10) for gas,
c) a tappet (17, 25) for closing the dosing pipe (16), wherein the tappet (17,25) is disposed on a movable rod (18),
**characterized by**
d) a device for providing a gas stream directed counter to the gas stream which flows from the dosing pipe (16) to the conduit pipe (10).
